# EUROPÄISCHE PATENTSCHRIFT

(11) **EP 3 138 173 B1**
(45) Veröffentlichungstag und Bekanntmachung des Hinweises auf die Patenterteilung: **19.02.2020**
(21) Anmeldenummer: 15712881.0
(22) Anmeldetag: 25.03.2015
(51) Int. Cl.: H02J 1/10, H02M 7/00

(54) **WANDLERMODUL ZUR UMWANDLUNG ELEKTRISCHER LEISTUNG UND WECHSELRICHTER FÜR EINE PHOTOVOLTAIKANLAGE MIT MINDESTENS ZWEI WANDLERMODULEN**
CONVERTER FOR CONVERTING ELECTRIC POWER AND INVERTER FOR A PHOTOVOLTAIC INSTALLATION WITH AT LEAST TWO CONVERTER MODULES
CONVERTISSEUR POUR CONVERTIR L'ÉNERGIE ÉLECTRIQUE ET ONDULEUR POUR UNE INSTALLATION PHOTOVOLTAÏQUE AVEC AU MOINS DEUX MODULES DE CONVERSION

(30) Priorität: 29.04.2014 DE 102014105985
(43) Veröffentlichungstag der Anmeldung: 08.03.2017
(73) Patentinhaber: SMA Solar Technology AG, 34266 Niestetal (DE)
(72) Erfinder: BERGER, Niels, 34266 Niestetal (DE)
(74) Vertreter: Lahnor, Peter
(86) Internationale Anmeldenummer: PCT/EP2015/056469
(87) Internationale Veröffentlichungsnummer: WO 2015/165658

(56) Entgegenhaltungen:
- EP-A2- 0 877 472
- DE-A1-102008 064 565
- JP-A- 2005 117 728
- US-A1- 2010 043 781
- US-A1- 2011 299 265
- US-A1- 2012 081 934
- US-A1- 2013 090 203
- US-A1- 2014 103 855

## Beschreibung

### TECHNISCHES GEBIET DER ERFINDUNG

Die Erfindung betrifft ein Wandlermodul zur Umwandlung elektrischer Leistung und einen Wechselrichter für eine Photovoltaikanlage mit mindestens zwei Wandlermodulen.

Wechselrichter für Photovoltaikanlagen dienen zur Umwandlung einer von einem Photovoltaik-Generator in Form eines elektrischen Gleichstroms erzeugten elektrischen Leistung in einen Wechselstrom zur Einspeisung in ein Wechselspannungsnetz. Dazu umfasst ein Wechselrichter regelmäßig einen eingangsseitigen Gleichspannungswandler zur Einstellung der am Photovoltaik-Generator anliegenden Gleichspannung, einen Gleichspannungs-Zwischenkreis und eine ausgangsseitige Wechselrichterbrücke.

### STAND DER TECHNIK

Aus der EP 1195877 A1 ist ein Stromrichtersystem mit durch einen Gleichspannungs-zwischenkreis verbundenen Stromrichtermodulen bekannt, wobei der Gleichspannungs-zwischenkreis zwei Gleichspannungssammelschienen und eine zwischen den Gleichspannungssammelschienen angeordnete Gleichspannungszwischenkreiskapazitaet umfasst. Dabei ist jedem der Stromrichtermodule ein Teil der Gleichspannungszwischenkreiskapazität zugeordnet, so dass jedem Stromrichtermodul ein angemessener Anteil der erforderlichen Gleichspannungszwischenkreiskapazität zugeordnet ist ("verteilter Zwischenkreis"), wobei dieser Anteil mindestens so groß ist, dass er den von diesem Modul in den Zwischenkreis eingebrachten Wechselstrom tragen kann. Dadurch kann ein defektes Stromrichtermodul von dem gemeinsamen Zwischenkreis abgekoppelt werden, so dass ein unterbrechungsfreier Weiterbetrieb der anderen Module am Zwischenkreis möglich ist.

Aus der DE 10062075 A1 ist ein Umrichter mit integrierten Zwischenkreiskondensatoren bekannt, bei dem herkömmliche Zwischenkreiskondensatoren auf mehrere Zwischenkreiskondensatoren kleinerer Kapazität aufgeteilt sind, die jeweils integrierter Bestandteil eines Halbbrücken- oder Brückenmoduls sein können. Ein Umrichter kann aus mehreren derartigen Halbbrücken- oder Vollbrückenmodulen bestehen, wobei die den einzelnen Modulen zugeordneten Kapazitäten anhand der elektrischen Eigenschaften der jeweiligen Module individuell festgelegt werden und ein Umrichter mindestens ein Modul umfasst.

Aus der WO 2012/162570 A1 ist ein modulares System aus an einen gemeinsamen Gleichspannungsbus gekoppelten Generatoren und Verbrauchern bekannt, bei dem Generatoren oder Verbraucher ohne weitere Änderungen an dem System aus dem System entfernt oder dem System hinzugefügt werden können. Dabei kann die Spannung am Gleichspannungsbus in Abhängigkeit von einer aktuellen erzeugten und einer aktuell verbrauchten Leistung zwischen einer minimalen und einer maximalen Arbeitsspannung schwanken, wobei die erzeugte Leistung oder die verbrauchte Leistung in Abhängigkeit von der aktuellen Spannung am Gleichspannungsbus gesteuert werden.

Aus der US 2004/125618 ist eine Vorrichtung zur Umwandlung elektrischer Leistung bekannt, die einen geregelten Gleichspannungszwischenkreis umfasst, an den flexibel verschiedene Quellen, z.B. Gleichspannungswandler für einen Photovoltaik-Generator oder für eine Batterie, sowie Senken, insbesondere eine Wechselrichterbrücke zur Einspeisung elektrischer Leistung in ein Wechselspannungsnetz, angeschlossen werden können. Der Gleichspannungszwischenkreis kann als Teil eines Wechselrichters einer Photovoltaikanlage oder auch als Teil eines der weiteren Gleichspannungswandler, beispielsweise eines Batterieladewandlers, ausgeführt sein. Dabei muss die von der Vorrichtung umgesetzte elektrische Leistung derart geregelt werden, dass eine Spannung des Gleichspannungszwischenkreises innerhalb vorgegebener Grenzen bleibt.

Aus der DE 102006011241 A1 ist eine Umrichter-Gerätereihe mit einer Vielzahl von Umrichter-Geräten bekannt, bei der jedes Umrichter-Gerät Netz- und Lastanschlüsse aufweist. Ein Umrichter-Gerät weist wenigstens ein Basisumrichter-Gerät, wobei die Basisumrichter-Geräte mittels ihrer Netz- und Lastanschlüsse elektrisch parallel schaltbar sind, so dass durch die Parallelschaltung mehrerer Basisumrichter-Geräte unter Verwendung einheitlicher Komponenten Umrichter-Geräte unterschiedlicher Leistungsklassen herstellbar sind.

Die US 2010/043781 A1 offenbart ein Trägersystem für einen Photovoltaik-Modul mit in Trägermodule des Trägersystem integrierten DC/AC-Wechselrichtern, wobei die DC/AC-Wechselrichter mittels Verbindungskabeln AC-seitig untereinander verbunden sind.

Aus der EP 0877472 A1 sind Stromrichter-Module mit einem Verschienungssystem für Leistungshalbleiter bekannt, wobei die Stromrichter-Module über Zuführungsbleche mit einem Gleichstromzwischenkreis verbunden werden können, so dass mehrere derart verbundene Stromrichter-Module einen Stromrichter ausbilden.

Aus der JP 2005117728 A1 ist ein Wechselrichter mit mehreren Leistungsmodulen bekannt, bei dem die Leistungsmodule Gleichstromanschlüsse aufweisen, die jeweils einen positiven und einen negativen Anschluss aufweisen und an verschiedenen Seiten der Leistungsmodule angeordnet sind.

### AUFGABE DER ERFINDUNG

Der Erfindung liegt die Aufgabe zugrunde, ein Wandlermodul zur Umwandlung elektrischer Energie aufzuzeigen, das einfach und flexibel für verschiedene Anwendungen einsetzbar und mit gleichartigen Wandlermodulen kombinierbar ist, sowie einen Wechselrichter für eine Photovoltaikanlage bereitzustellen, der mindestens zwei Wandlermodule umfasst und einfach konfigurierbar und erweiterbar ist.

### LÖSUNG

Die Aufgabe wird durch einen Wechselrichter mit den Merkmalen des unabhängigen Patentanspruches 1 gelöst. Bevorzugte Ausführungsformen sind in den abhängigen Patentansprüchen definiert.

### BESCHREIBUNG DER ERFINDUNG

Ein Wandlermodul zum Umwandeln elektrischer Leistung mittels einer Wandlerschaltung mit mindestens einem getaktet angesteuerten leistungselektronischen Halbleiterschalter umfasst ein Gehäuse, einen ersten Zwischenkreisanschluss und eine in dem Gehäuse angeordnete und mit dem ersten Zwischenkreisanschluss sowie mit der Wandlerschaltung verbundene Kapazität zur Stabilisierung einer an dem ersten Zwischenkreisanschluss anliegenden Gleichspannung. Das Wandlermodul ist dadurch gekennzeichnet, dass es einen mit der Kapazität und mit dem ersten Zwischenkreisanschluss verbundenen zweiten Zwischenkreisanschluss aufweist. Dabei sind der erste und der zweite Zwischenkreisanschluss zur Verbindung mit Zwischenkreisanschlüssen weiterer Wandlermodule zum Umwandeln elektrischer Leistung gestaltet.

Über die beiden Zwischenkreisanschlüsse kann das Wandlermodul einfach mit weiteren gleichartigen Wandlermodulen verbunden werden und flexibel eingesetzt werden. Insbesondere dadurch, dass neben dem ersten Zwischenkreisanschluss ein zweiter Zwischenkreisanschluss vorhanden ist, kann eine grundsätzlich beliebige Anzahl von Wandlermodulen miteinander in Form einer Kette verbunden werden. Darüber hinaus kann die Kapazität des Wandlermoduls mit der Kapazität weiterer Wandlermodule verbunden werden und einen Gesamt-Zwischenkreis bilden, so dass die Kapazität des Wandlermoduls kleiner ausgelegt werden kann als für die Umwandlung der elektrischen Nennleistung durch das einzelne Wandlermodul eigentlich notwendig.

Der erste und der zweite Zwischenkreisanschluss können gegenüberliegend am Gehäuse des Wandlermoduls angeordnet und insbesondere als miteinander kompatible Steckverbinder ausgeführt sein, wobei die Steckverbinder insbesondere als Gegensteckverbinder aus einem Stecker und einer zum Stecker kompatiblen Buchse realisiert sein können. Dadurch wird ermöglicht, das mehrere Wandlermodule räumlich in Form einer Kette neben- bzw. hintereinander angeordnet werden können, wobei die elektrische Verbindung zwischen den Wandlermodulen mit einfachen Mitteln, d.h. über eine gradlinige leitende Verbindung, z.B. mittels ein flexibles Kabel, oder durch direktes Zusammenstecken der miteinander kompatiblen Gegensteckverbinder herstellbar ist. Darüber hinaus kann das Herstellen der elektrischen Verbindung einhergehen mit einer mechanischen Verbindung der Wandlermodule, indem die Gehäuse der Wandlermodule über geeignete mechanisch kompatible Arretierungen miteinander verbunden werden, wobei diese mechanische Verbindung gleichzeitig zu einem Zusammenführen der Gegensteckverbinder und damit einem Herstellen der elektrischen Verbindung führt.

Ein solches Zusammenstecken wird besonders vorteilhaft dadurch ermöglicht, dass die kompatiblen Steckverbinder an gegenüberliegenden Seiten des Gehäuses des Wandlermoduls angeordnet sind. Dabei ist die Anordnung der Steckverbinder insbesondere einander spiegelbildlich gegenüber an den gegenüberliegenden Seiten des Gehäuses, wobei die Spiegelachse mittig zwischen parallel zueinander liegenden Seiten des Gehäuses liegt. Mithin können die Zwischenkreisanschlüsse derart angeordnet sein, dass sie in einer Montageposition einer zulässigen Wandmontage des Wandlermoduls entlang einer horizontalen oder einer vertikalen Verbindungslinie angeordnet sind, so dass eine fluchtende Anordnung von Wandlermodulen neben- bzw. übereinander ermöglicht wird.

Während im Falle der als Gegensteckverbinder ausgeführten Zwischenkreisanschlüsse somit einzelne Wandlermodule direkt aneinandergesteckt werden können, können insbesondere im Falle der kompatiblen Steckverbinder auch Zwischenstücke zu Hilfe genommen werden. Dabei können die Zwischenstücke beispielsweise starre oder teilflexible Leiter sein, die beidseitig zu den Zwischenkreisanschlüssen kompatible Steckverbinder aufweisen, so dass zwischen diesen und den Zwischenkreisanschlüssen jeweils Gegensteckverbindungen herstellbar sind.

Unter den Begriff Steckverbindung fallen in diesem Zusammenhang auch andere Arten der Verbindung von elektrischen Kontakten miteinander, insbesondere Schraub-, Klemm oder Schnappverbindungen; auch Löt- oder Schweißverbindungen sind denkbar, wobei diese jedoch im Vergleich mit den anderen genannten Verbindungsarten die Flexibilität des Wandlermoduls geringfügig vermindern.

Das Wandlermodul kann mindestens einen Leistungsanschluss aufweisen, der zum Transfer elektrischer Leistung in das Wandlermodul hinein und/oder aus dem Wandlermodul heraus geeignet ist. Insbesondere ist ein solcher Leistungsanschluss zur Verbindung mit einer elektrische Leistung erzeugenden und/oder verbrauchenden Einheit vorgesehen. Eine elektrische Leistung erzeugende Einheit ist insbesondere ein Gleichstrom-Generator. Eine elektrische Leistung verbrauchende Einheit kann insbesondere eine Gleichstrom-Last, beispielsweise einen Gleichstromkreis mit einem Gleichstrommotor oder einem Heizelement, oder eine Wechselstromlast, beispielweise einen Wechselstrommotor, ein Insel- oder Haushaltsnetz oder ein öffentliches Wechselspannungsnetz umfassen. Ein Speicherelement wie z.B. eine Batterie oder ein Kondensator mit hoher Kapazität stellt in diesem Zusammenhang eine elektrische Leistung bidirektional sowohl erzeugende als auch verbrauchende Einheit dar. Ebenso kann elektrische Leistung bidirektional mit einem Wechselspannungsnetz ausgetauscht werden.

Ein erfindungsgemäßer Wechselrichter für eine Energieerzeugungsanlage umfasst mindestens zwei Wandlermodule zum Umwandeln elektrischer Leistung. Die Wandlermodule weisen jeweils ein Gehäuse, mindestens einen Leistungsanschluss und einen ersten Zwischenkreisanschluss auf. Weiterhin weisen die Wandlermodule eine mit dem ersten Zwischenkreisanschluss verbundene Kapazität zur Stabilisierung einer an dem ersten Zwischenkreisanschluss anliegenden Gleichspannung auf und umfassen eine Wandlerschaltung mit mindestens einem getaktet angesteuerten leistungselektronischen Halbleiterschalter. Dabei ist die Wandlerschaltung eines der mindestens zwei Wandlermodule als Gleichspannungswandler und die Wandlerschaltung eines anderen der mindestens zwei Wandlermodule als Wechselrichterbrücke ausgeführt. Der Wechselrichter ist dadurch gekennzeichnet, dass die mindestens zwei Wandlermodule jeweils einen mit der Kapazität und mit dem ersten Zwischenkreisanschluss des jeweiligen Wandlermoduls verbundenen zweiten Zwischenkreisanschluss aufweisen und dass die mindestens zwei Wandlermodule über jeweils einen ihrer Zwischenkreisanschlüsse miteinander verbunden sind, so dass die über die Zwischenkreisanschlüsse verbundenen Kapazitäten einen gemeinsamen Gleichspannungszwischenkreis bilden..

Ein derart aufgebauter Wechselrichter ist bereits in seiner Minimalkonfiguration mit nur zwei Wandlermodulen dazu geeignet, eine am Leistungsanschluss des den Gleichspannungswandler umfassenden Wandlermoduls anliegende elektrische Leistung auf ein anderes Spannungsniveau zu wandeln, die elektrische Leistung über die Verbindung der Zwischenkreisanschlüsse der Wandlermodule an das die Wechselrichterbrücke umfassende Wandlermodul zu übertragen und sodann als Wechselstrom über dessen Leistungsanschluss auszugeben. Dabei ergänzen sich insbesondere die den beiden Wandlermodulen zugeordneten Kapazitäten zu einer Gesamt-Zwischenkreiskapazität.

Darüber hinaus kann der Wechselrichter flexibel erweitert werden, indem die in dieser Minimalkonfiguration frei gebliebenen Zwischenkreisanschlüsse mit den Zwischenkreisanschlüssen weiterer Wandlermodule verbunden werden. Derart verbundene weitere Wandlermodule können - je nachdem welche Wandlerschaltung sie aufweisen - ihrerseits elektrische Leistung über ihre Zwischenkreisanschlüsse abgeben und/oder aufnehmen, welche wiederum aufgrund der Verbindung der Zwischenkreisanschlüsse allen Wandlermodulen zur weiteren Verarbeitung zur Verfügung steht bzw. von diesen zur Verfügung gestellt wird. Durch eine derartige Erweiterung erhöht sich zudem die Gesamt-Zwischenkreiskapazität des Wechselrichters um die den hinzugefügten Wandlermodulen zugeordneten Kapazitäten.

Insbesondere können die mit den Zwischenkreisanschlüssen der mindestens zwei Wandlermodule verbundenen Kapazitäten derart ausgelegt sein, dass die Variation der an den Zwischenkreisanschlüssen anliegenden Spannung auf ein für den Betrieb des Wechselrichters verträgliches Maß begrenzt ist. Beispielsweise kann diese Variation, d.h. die Schwankungsbreite der Spannung des Gesamt-Zwischenkreises des Wechselrichters auf eine vorgegebene maximale Variation begrenzt sein, wobei die maximale Variation insbesondere bei einem Betrieb des Wechselrichters mit einer elektrischen Maximalleistung auftritt. Darüber hinaus darf die Gesamt-Zwischenkreisspannung eine zum Einspeisen eines Wechselstroms in ein Wechselspannungsnetz nötige Minimalspannung als untere Grenze nicht unterschreiten, wenn der Leistungsanschluss des die Wechselrichterbrücke umfassenden Wandlermoduls an ein solches Wechselspannungsnetz angeschlossen ist und elektrische Leistung darin einspeisen soll. Eine derart begrenzte Variation wird von einem erfindungsgemäßen Wechselrichter nur dann gewährleistet, wenn die Kapazität eines der mindestens zwei Wandlermodule über mindestens einen der Zwischenkreisanschlüsse mit mindestens einer Kapazität eines weiteren der mindestens zwei Wandlermodule verbunden ist und somit eine gegenüber den einzelnen Kapazitäten der mindestens zwei Wandlermodule vergrößerte Gesamt-Zwischenkreiskapazität wirksam ist, die die Gesamt-Zwischenkreisspannung hinreichend stabilisiert. Die elektrische Maximalleistung fließt dabei von einem oder mehreren der Leistungsanschlüsse der mindestens zwei Wandlermodule über die Zwischenkreisanschlüsse zu einem oder mehreren anderen der Leistungsanschlüsse.

Die elektrische Maximalleistung ist eine Eigenschaft des Wechselrichters als Ganzem und nicht unbedingt identisch mit einer insbesondere durch die Eigenschaften der Halbleiterschalter der den einzelnen Wandlermodulen zugeordneten Wandlerschaltungen vorgegebenen Maximalleistung eines einzelnen Wandlermoduls. Insbesondere kann die Maximalleistung des Wechselrichters erhöht werden, indem mehrere Wandlermodule, die gleichartige Wandlerschaltungen aufweisen, über die Zwischenkreisanschlüsse miteinander verbunden werden. Dadurch, dass sich durch eine derartige Verbindung der Zwischenkreisanschlüsse auch die Gesamt-Zwischenkreiskapazität erhöht, wird die maximal erlaubte Variation der Gesamt-Zwischenkreisspannung auch nach der Erhöhung der Maximalleistung des Wechselrichters ohne weiteres eingehalten und nicht überschritten.

In einer Ausführungsform wird der erste Zwischenkreisanschluss eines der mindestens zwei Wandlermodule mit dem zweiten Zwischenkreisanschluss eines anderen der mindestens zwei Wandlermodule verbunden. Insbesondere können die Zwischenkreisanschlüsse eines jeden der mindestens zwei Wandlermodule gegenüberliegend an dessen Gehäuse angeordnet sein. Dadurch kann erreicht werden, dass die Wandlermodule in einer Reihe neben- oder übereinander angeordnet werden können, wobei die jeweils äußeren der Wandlermodule einer solchen Reihe jeweils einen noch freien Zwischenkreisanschluss aufweisen, die zum Zwecke der flexiblen Erweiterung des Wechselrichters mit den Zwischenkreisanschlüssen weiterer Wandlermodule verbunden werden können.

In einer weiteren Ausführungsform weisen die mindestens zwei Wandlermodule eine gleiche Formgebung auf und sind unter direkter Verbindung, d.h. insbesondere einer horizontalen bzw. vertikalen Verbindung, jeweils eines ihrer entsprechenden Zwischenkreisanschlüsse montiert. Dabei sind der erste und der zweite Zwischenkreisanschluss eines jeden der mindestens zwei Wandlermodule derart zueinander angeordnet, dass die mindestens zwei Wandlermodule mit einer Gehäuseseite entlang einer horizontalen oder vertikalen Ausrichtungslinie bündig zueinander ausgerichtet sind.

Die direkte Verbindung kann über als miteinander kompatible Steckverbinder ausgeführte Zwischenkreisanschlüsse realisiert werden, wobei die Steckverbinder insbesondere als Gegensteckverbinder aus einem Stecker und einer zum Stecker kompatiblen Buchse ausgeführt sein können. Dabei kann die Verbindung durch direktes Aneinanderstecken der Zwischenkreisanschlüsse hergestellt werden, so dass die Wandlermodule unmittelbar benachbart positioniert werden. Alternativ kann die Verbindung über Zwischenstücke, beispielsweise starre oder teilflexible Leiter, oder auch mittels flexibler Kabel mit geeigneten Endstücken hergestellt werden. Der Begriff Steckverbindung umfasst in diesem Zusammenhang auch andere Arten der Verbindung von elektrischen Kontakten miteinander, insbesondere Schraub-, Klemm oder Schnappverbindungen; auch Löt- oder Schweißverbindungen sind denkbar, wobei letztere jedoch im Vergleich mit den anderen genannten Verbindungsarten die Flexibilität des Wandlermoduls geringfügig vermindern.

In einer weiteren Ausführungsform umfassen die Wandlermodule eines Wechselrichters Steuereinrichtungen zur Ansteuerung der Halbleiterschalter des jeweiligen Wandlermoduls sowie Kommunikationsmittel zur Herstellung einer Kommunikationsverbindung zwischen den einzelnen Wandlermodulen. Dabei können die Kommunikationsmittel als drahtlose Schnittstellen oder insbesondere auch als Kommunikationsanschlüsse zur leitungsgebundenen Kommunikation ausgebildet sein, wobei auch eine Lichtleiterverbindung als leitungsgebunden anzusehen ist und die Kommunikationsanschlüsse der Wandlermodule miteinander verbunden sind. Die Verbindung der Kommunikationsanschlüsse kann wie in Zusammenhang mit dem Verbinden der als Gegensteckverbinder ausgeführten Zwischenkreisanschlüsse gleichzeitig mit dem Herstellen einer mechanischen Verbindung der Gehäuse benachbarter Wandlermodule hergestellt werden, indem die Kommunikationsanschlüsse als kompatible Gegensteckverbinder ausgeführt sein können.

Die Steuereinrichtungen können mit den Kommunikationsmitteln verbunden und dazu eingerichtet sein, über die Kommunikationsmittel und die zwischen den Kommunikationsmitteln mehrerer Wandlermodule herstellbare Kommunikationsverbindung miteinander zu kommunizieren. Dadurch können Betriebsparameter der einzelnen Wandlermodule aufeinander abgestimmt werden, wobei die Betriebsparameter und damit der Betrieb des Wechselrichters insgesamt insbesondere von den jeweiligen Eigenschaften der einzelnen Wandlermodule abhängt. Eine derartige Abstimmung kann bei einer Änderung der Anzahl oder des Typs der Wandlermodule, insbesondere bei einer Erweiterung des Wechselrichters mit zusätzlichen Wandlermodulen auf die dadurch veränderten Betriebsbedingungen abgestimmt werden.

Darüber hinaus ist denkbar, die Kommunikation zwischen den Wandlermodulen als Master-Slave-Systems aufzubauen, wobei die einem der Wandlermodule zugeordnete Steuereinheit die Funktionen eines Masters ausführt und insbesondere auch den Betrieb des Wechselrichters insgesamt steuern kann, während alle den weiteren Wandlermodulen zugeordneten Steuereinheiten als Slaves mit vom Master vorgegebenen Betriebsparametern betrieben werden.

Der erfindungsgemäße Wechselrichter umfasst mindestens zwei Wandlermodule, von denen mindestens eines einen Gleichspannungswandler und mindestens ein weiteres eine Wechselrichterbrücke aufweist. In einer bevorzugten Ausführungsform dieses Wechselrichters kann mindestens ein Leistungsanschluss des den Gleichspannungswandler aufweisenden Wandlermoduls zum Anschluss eines Gleichstrom-Generators, einer Gleichstrom-Batterie oder einer Gleichstrom-Last ausgelegt sein. Weiterhin kann ein Leistungsanschluss des die Wechselrichterbrücke aufweisenden Wandlermoduls zum Anschluss eines Wechselspannungsnetzes oder eines Wechselstrom-Verbrauchers ausgelegt sein. Insbesondere kann der Wechselrichter in einer Minimalkonfiguration genau zwei Wandlermodule - ein erstes Wandlermodul mit einem Gleichspannungswandler und ein zweites Wandlermodul mit einer Wechselrichterbrücke - aufweisen, wobei an einen Leistungsanschluss des ersten Wandlermoduls ein Photovoltaik-Generator und an einen Leistungsanschluss des zweiten Wandlermoduls ein Wechselspannungsnetz anschließbar ist. In einer derartigen Konfiguration ist ein erfindungsgemäßer Wechselrichter besonders vorteilhaft in einer Energieerzeugungsanlage, insbesondere in einer netzgekoppelten Photovoltaik-Anlage einsetzbar. Dabei ist der Wechselrichter aufgrund seines modularen Aufbaus und der Eigenschaften der Wandlermodule, insbesondere aufgrund der Eigenschaften der Zwischenkreiskapazitäten und der Konfiguration der Zwischenkreisanschlüsse der Wandlermodule, durch Hinzufügen von weiteren und/oder durch Austausch von vorhandenen Wandlermodulen flexibel erweiterbar. Der Wechselrichter kann sowohl hinsichtlich der Vergrößerung der umsetzbaren elektrischen Maximalleistung als auch hinsichtlich der Ergänzung von Funktionalitäten der Energieerzeugungsanlage erweitert werden. So kann beispielsweise ein Energiespeicher, z.B. eine Batterie, ergänzt werden, oder auch ein autarker, vom PV-Generator und/oder von einer Batterie gespeisten Wechselstrom-Anschluss zur Notstromversorgung oder Ähnlichem zur Verfügung gestellt werden.

Im Folgenden seien beispielhaft ohne Anspruch auf Vollständigkeit weitere Anwendungen für Wandlermodule bzw. erfindungsgemäße Wechselrichter genannt.

Mittels eines Wandlermoduls kann eine - ggf. bidirektionale - Übertragung elektrischer Leistung von einem Leistungsanschluss des Wandlermoduls zu der Zwischenkreiskapazität des Wandlermoduls erfolgen, wobei an dem Leistungsanschluss - je nach Konfiguration der Wandlerschaltung des Wandlermoduls - eine Batterie, eine Brennstoffzelle, eine Wind- oder Wasserkraftgenerator, ein Dieselaggregat, ein öffentliches Wechselspannungsnetz, ein Wechselspannungs-Inselnetz mit Generatoren und/oder Verbrauchern, und/oder ein einzelner Wechselstromverbraucher anschließbar ist.

Ein Wandlermodul kann aufgrund der von ihm umsetzbaren elektrischen Leistung in eine Leistungsklasse eingeteilt sein, wobei die Wandlermodule eines Wechselrichters verschiedene Leistungsklassen aufweisen können. Verschiedene Wandlermodule können verschiedene Spannungsstufen, d.h. verschiedene Übersetzungsverhältnisse zwischen zulässigen Spannungen an einem Leistungsanschluss eines Wandlermoduls und der Spannung an dessen Zwischenkreisanschlüssen aufweisen.

Leistungsanschlüsse von Wandlermodulen, die eine Wechselrichterbrücke aufweisen, können einphasig oder mehrphasig, insbesondere dreiphasig und mit oder ohne Anschluss für einen Neutralleiter ausgeführt sein.

Leistungsanschlüsse von Wandlermodulen, die einen Gleichspannungswandler aufweisen, können einfach oder mehrfach ausgeführt sein, so dass ein Generator oder mehrere Generatoren anschließbar sind, wobei im Falle mehrerer anschließbarer Generatoren die elektrischen Leistungen dieser Generatoren parallel zusammengeführt und von einer Wandlerschaltung oder einzeln von mehreren zwischenkreisseitig parallel geschalteten Wandlerschaltungen verarbeitet werden können. Analoge Konfigurationen sind für Wandlermodule denkbar, deren Leistungsanschlüsse zum Anschluss von Energiespeicher wie Batterien eingerichtet sind. Dabei können die Wandlermodule insbesondere anhand speziell adaptierter, d.h. insbesondere speziell programmierter Steuereinrichtungen für den bidirektionalen Austausch elektrischer Leistung mit Batterien verschiedenster Typen, beispielsweise mit Lithium-Ionen-Batterien, Blei-Batterien oder elektrochemische Batterien (z.B. Redox-Flow-Zellen) eingerichtet sein.

Zu den Vorteilen der Erfindung gehört, dass ein modulares System mit einer minimalen Anzahl an Schnittstellen realisierbar ist. Dabei umfasst jedes Modul "die eine Hälfte" einer gewünschten Anwendung von einem Leistungsanschluss bis einem Zwischenkreis bzw. ab dem Zwischenkreis zum Leistungsanschluss, wobei jedes Modul insbesondere einen Zwischenkreis bereitstellen muss, der (nur) die halbe Größe des für die durch das jeweilige Modul umsetzbare elektrische Leistung umfasst. Damit können komplette Anwendungen, insbesondere Wechselrichten aber auch andere Wandlungsformen der elektrischen Leistung, durch flexibles Zusammensetzen von wenigen Einzelkomponenten realisiert werden, wobei verschiedene Energie-Quellen (PV, Wind, Brennstoffzelle, Batterie, AC-Netz usw.) mit verschiedenen Energie-Senken (Brennstoffzelle, Batterie, AC-Netz, AC-Insel-Verbraucher, usw.) quasi-beliebig kombinierbar sind. Die gemeinsame Leistungs-Schnittstelle ist der über die Zwischenkreisanschlüsse kontaktierbare Gesamt-Zwischenkreis, und ein Austausch eines Modules ist möglich, ohne hierfür andere Module abbauen zu müssen.

Insgesamt ist diese ösung praktikabler, effizienter und auch kostengünstiger, insbesondere sobald eine gewisse anwendungsseitige Flexibilität gewünscht ist und da Komponenten der Module, insbesondere die Zwischenkreiskapazitäten nur einmal vorgehalten werden müssen, aber bei vielen Anwendungen eingesetzt werden können.

Ein Wandlermodul kann - je nach Ausführungsform und konkret an dessen Leistungsanschluss anschließbare Komponenten, d.h. Quellen und/oder Senken elektrischer Leistung - spezifische Zusatzfunktionen umfassen. Ein eine Wechselrichterbrücke umfassendes Wandlermodul kann eine Einrichtung zur Netzüberwachung und/oder zur Netztrennung bereitstellen. Auch kann beispielsweise ein einen Gleichspannungswandler umfassendes Wandlermodul eine Lichtbogenerkennung für und/oder eine Powerline-Kommunikation über an seinen Leistungsanschluss anschließbare Gleichstromleitungen bereitstellen, wobei diese Gleichstromleitungen das Wandlermodul wiederum beispielsweise mit einem Photovoltaik-Generator und/oder mit einem ggf. zwischengeschalteten Powerline-Transceiver, der insbesondere in einem Generatoranschlusskasten angeordnet sein kann, verbinden.

Weiterhin kann ein Wandlermodul eine Einrichtung zur Anpassung der am Leistungsanschluss des Wandlermoduls anliegenden Gleichspannung umfassen, die dazu eingerichtet ist, diese Gleichspannung auf einen Wert einzustellen, bei der ein am Leistungsanschluss des Wandlermoduls angeschlossener Photovoltaik-Generator seine maximale elektrische Leistung abgibt (sog. Maximum Power Point Tracking, kurz: MPP-Tracking).

Weiterhin können Wandlermodule verschiedenste Arten von Sensoren umfassen, insbesondere solche zur Erfassung von elektrischen Betriebsparametern wie Strömen und Spannungen sowie zur Erfassung sonstiger Betriebsparameter wie z.B. von Temperaturen. Diese Betriebsparameter können von der Steuereinrichtung des jeweiligen Wandlermoduls verarbeitet und/oder über die Kommunikationsmittel an weitere Wandlermodule übermittelt werden, wobei die Steuereinrichtungen die Wandlerschaltung des jeweiligen Wandlermoduls gegebenenfalls in Abhängigkeit von Betriebsparametern des jeweiligen und/oder der weiteren Wandlermodule betreiben.

Neben den den Wandlermodulen zugeordneten Steuereinrichtungen kann eine übergeordnete Steuereinrichtung vorgesehen sein, die für einen Betrieb einer mehrere Wandlermodule umfassenden Vorrichtung relevante Funktionen alternativ oder zusätzlich zu den den Wandlermodulen zugeordneten Steuereinrichtungen übernehmen kann. So kann insbesondere in einem erfindungsgemäßen Wechselrichter eine derartige übergeordnete Steuereinrichtung beispielsweise zur Absicherung des Wechselrichters vor Fehlfunktionen oder Netzfehlern (z.B. globaler Not-Aus bzw. sog. Fault-Ride-Through), zur Koordination des Betriebs der einzelnen Wandlermodule (z.B. Festlegung, ob Verbraucher getrennt werden, ob Batterien geladen oder entladen werden sollen, usw.) oder auch zur Synchronisation (Einigung auf eine gemeinsame Zwischenkreisspannung) eingerichtet sein.

Die Gehäuse der Wandlermodule können Kühleinrichtungen, insbesondere rückseitig angeordnete Kühlrippen oder Kühlkörper aufweisen. Die Kühleirichtungen können derart angeordnet sein, dass sich bei einem mehrere Wandlermodule umfassenden Wechselrichter ein durchgängiger Kühlkanal ergibt, der sich bei neben- oder übereinander angeordneten Wandlermodulen durchgängig horizontal bzw. vertikal erstreckt. An einem Ende eines derartigen gemeinsamen Kühlkanals kann ein Kühlaggregat, beispielsweise ein Lüfter angeordnet sein, der einen den gesamten Wechselrichter kühlenden Kühlluftstrom erzeugt.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt ein Wandlermodul,
- Fig. 2: zeigt einen erfindungsgemäßen Wechselrichter in einer ersten Ausführungsform mit zwei Wandlermodulen,
- Fig. 3: zeigt einen erfindungsgemäßen Wechselrichter in einer zweiten Ausführungsform mit vier Wandlermodulen, eingangsseitig angeschlossenen PV-Generatoren sowie ausgangseitig angeschlossenem Wechselspannungsnetz, und
- Fig. 4: zeigt einen erfindungsgemäßen Wechselrichter in einer dritten Ausführungsform mit vier Wandlermodulen, eingangsseitig angeschlossenem PV-Generator, einer Batterie sowie ausgangseitig angeschlossenem Wechselspannungsnetz und Wechselstromverbraucher.

### FIGURENBESCHREIBUNG

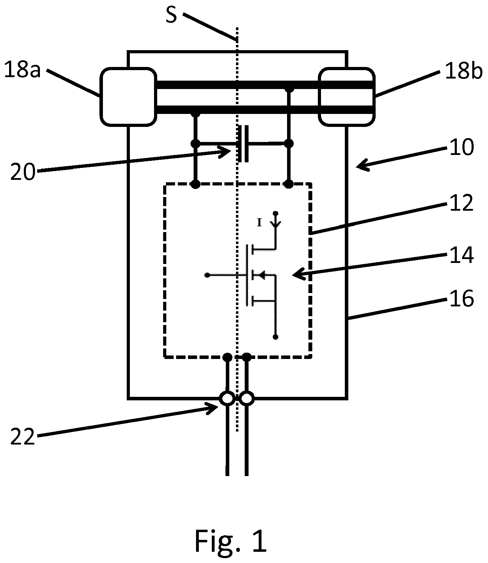

**Fig. 1** zeigt ein Wandlermodul 10, das eine Wandlerschaltung 12 mit einem leistungselektronischen Halbleiterschalter 14 und ein Gehäuse 16 umfasst. Die Wandlerschaltung 12 ist mit Zwischenkreisanschlüssen 18a und 18b verbunden. Eine Kapazität 20 ist mit der Wandlerschaltung 12 und den Zwischenkreisanschlüssen 18a, 18b verbunden. Weiterhin ist die Wandlerschaltung mit einem Leistungsanschluss 22 verbunden. Die Wandlerschaltung 12 kann als Gleichspannungswandler oder als Wechselrichterbrücke ausgeführt sein und unidirektional oder bidirektional elektrische Leistung zwischen dem Leistungsanschluss 22 und der Kapazität 20 bzw. den Zwischenkreisanschlüssen 18a, 18b transferieren.

Im Falle einer Ausführung als Gleichspannungswandler kann die Wandlerschaltung 12 konkret beispielsweise als Hochsetzsteller, als Tiefsetzsteller oder als Hochtiefsetzsteller ausgeführt sein und einen oder mehrere Halbleiterschalter 14 sowie ggf. weitere elektrische oder elektronische Bauteile wie Dioden, Drossel oder Kondensatoren umfassen. Die Wandlerschaltung 12 kann mehrere in Reihe oder parallel geschaltete Gleichspannungswandler umfassen, wobei speziell im Falle mehrerer zwischenkreisseitig parallel geschalteter Gleichspannungswandler jedem Gleichspannungswandler jeweils ein eigener Leistungsanschluss 22 zugeordnet sein kann.

Im Falle einer Ausführung als einphasige oder mehrphasige Wechselrichterbrücke kann die Wandlerschaltung 12 konkret beispielsweise als Halbbrücke, als Vollbrücke (H4-, H5- oder H6-Brücke) oder als NPC-Brücke ausgeführt sein und einen oder mehrere Halbleiterschalter 14 sowie ggf. weitere elektrische oder elektronische Bauteile wie Dioden, Drossel oder Kondensatoren umfassen. Auch in diesem Falle kann die Wandlerschaltung 12 mehrere in Reihe oder parallel geschaltete Wechselrichterbrücken umfassen, wobei speziell im Falle mehrerer zwischenkreisseitig parallel geschalteter Wechselrichterbrücken jeder Wechselrichterbrücke jeweils ein eigener Leistungsanschluss 22 zugeordnet sein kann.

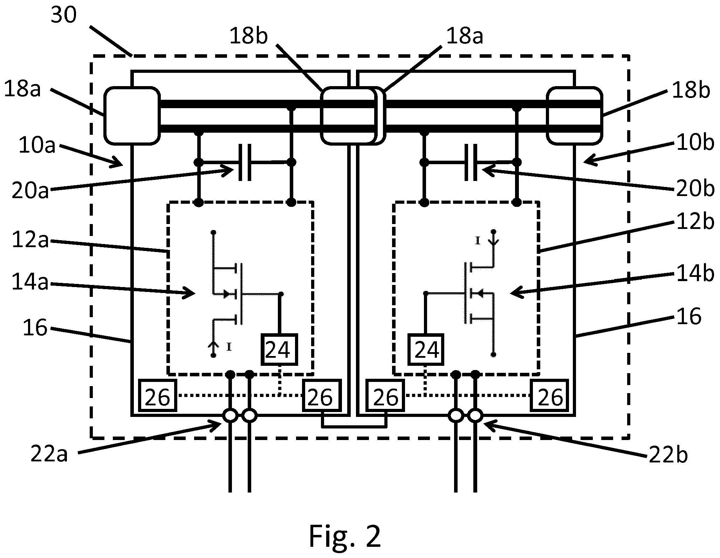

Die Zwischenkreisanschlüsse 18a, 18b können als miteinander kompatible Steckverbinder ausgeführt sein. In der konkreten Ausführungsform gemäß Fig. 1 ist der Zwischenkreisanschluss 18a als Buchse und der andere Zwischenkreisanschluss 18b als Stecker ausgeführt, so dass die Kombination der Zwischenkreisanschlüsse 18a, 18b eine Gegensteckverbindung darstellt und die Zwischenkreisanschlüsse 18a, 18b insbesondere zur Verbindung mit Zwischenkreisanschlüssen 18b bzw. 18a weiterer Wandlermodule 10 gestaltet sind. Dies wird aus den in den folgenden Figuren dargestellten erfindungsgemäßen Wechselrichtern 30 (siehe Figs. 2 bis 4) deutlich, die jeweils aus mehreren Wandlermodulen 10 aufgebaut sind.

Die Zwischenkreisanschlüsse 18a, 18b können an gegenüberliegenden Seiten des Gehäuses 16 angeordnet sein. Insbesondere können die Zwischenkreisanschlüsse 18a, 18b einander spiegelbildlich gegenüber angeordnet sein, wobei eine Spiegelachse S mittig zwischen und parallel zu parallel zueinander liegenden Seiten des Gehäuses 16 liegt.

Fig. 2 zeigt einen erfindungsgemäßen Wechselrichter 30, der zwei Wandlermodule 10a und 10b umfasst. Wie durch die Orientierung der Halbleiterschalter 14a, 14b in den Wandlerschaltungen 14a, 14b der Wandlermodule 10a, 10b angedeutet, erfüllen die Wandlermodule 10a, 10b unterschiedliche Funktionen. Konkret ist die Wandlerschaltung 12a des Wandlermoduls 10a als Gleichspannungswandler und die Wandlerschaltung 12b des Wandlermoduls 10b als Wechselrichterbrücke aufgebaut. Dadurch ist der Wechselrichter 30 dazu eingerichtet, eine elektrische Leistung eines am Leistungsanschluss 22a des Wandlermoduls 10a anschließbaren Gleichstrom-Generators zunächst mittels der Wandlerschaltung 12a auf ein anderes Gleichspannungsniveau zu wandeln und in einen Gleichspannungszwischenkreis einzuspeisen. Der Gleichspannungszwischenkreis wird aus den Kapazitäten 20a und 20b gebildet, welche über den Zwischenkreisanschluss 18b des Wandlermoduls 10a und den Zwischenkreisanschluss 18a des Wandlermoduls 10b miteinander verbunden sind. Die als Wechselrichterschaltung aufgebaute Wandlerschaltung 12b des Wandlermoduls 10b kann die derart gewandelte elektrische Leistung aus dem Gleichspannungszwischenkreis entnehmen und mittels des oder der Halbleiterschalter 14b in einen Wechselstrom wandeln. Dieser Wechselstrom kann über den Leistungsanschluss 22b des Wandlermoduls 10b ausgegeben und insbesondere in ein an den Leistungsanschluss 22b anschließbares Wechselspannungsnetz eingespeist werden.

Die Wandlermodule 10a, 10b weisen Steuereinrichtungen 24 auf, die zur Steuerung der Wandlerschaltungen 12a, 12b und insbesondere zur Ansteuerung der Halbleiterschalter 14a, 14b eingerichtet sind. Zusätzlich weisen die Wandlermodule Kommunikationsmittel, die in Fig. 2 konkret als Kommunikationsanschlüsse 26 dargestellt sind. Die Wandlermodule 10a, 10b sind über die Kommunikationsanschlüsse 26 miteinander verbunden.

Die Steuereinrichtungen 24 können die Halbleiterschalter 14a, 14b mittels getakteter Ansteuersignale ansteuern. Dabei kann die Ansteuerung in Form einer Steuerung oder Regelung implementiert sein, wobei die Steuereinrichtungen 24 Messdaten von hier nicht dargestellten Strom- und Spannungssensoren im Rahmen der Steuerung oder Regelung verwenden können. Über die mit den Steuereinheiten 24 verbundenen Kommunikationsmittel, insbesondere über die Kommunikationsanschlüsse 26, können die Steuereinrichtungen 24 untereinander oder ggf. mit einer nicht dargestellten übergeordneten Steuereinrichtung die für die Steuerung der Wandlerschaltungen 12a, 12b im Verbund relevanten Daten austauschen. Diese Daten können sowohl Messdaten und aktuelle Ansteuerparameter als auch daraus ermittelte Metadaten wie z.B. die aktuell von einem Wandlermodul 10a, 10b umgesetzte elektrische Leistung umfassen. Darüber hinaus kann die Steuereinrichtung 24 eines der Wandlermodule 10a, 10b als Master konfiguriert sein, so dass die Steuereinrichtung 24 neben der Ansteuerung der ihm direkt zugeordneten Wandlerschaltung 12a bzw. 12b anhand einer Übermittlung von Steuersignalen an die Steuereinheiten 24 der weiteren Wandlermodule 10a, 10b des Wechselrichters 30 auch den Betrieb dieser weiteren Wandlermodule 10a, 10b beeinflusst. Beispielsweise kann auf diese Weise ein Sollwert für eine Spannung an den Zwischenkreisanschlüssen 18a, 18b vorgegeben werden, die als Zielgröße im Rahmen einer Regelung von allen Steuereinheiten 24 verwendet werden soll.

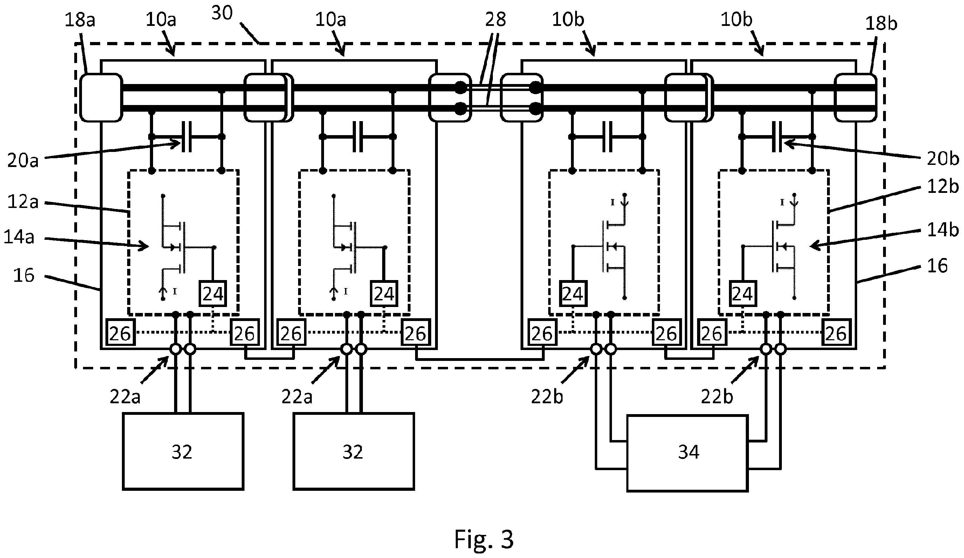

**Fig. 3** zeigt eine Ausführungsform eines Wechselrichters 30, die sich von der Ausführungsform gemäß Fig. 2 dadurch unterscheidet, dass statt eines Wandlermoduls 10a nun zwei Wandlermodule 10a vorgesehen sind, die jeweils eine als Gleichspannungswandler ausgeführte Wandlerschaltung 12a umfassen. Darüber hinaus sind statt eines Wandlermoduls 10b nun zwei Wandlermodule 10b vorgesehen, die jeweils eine als Wechselrichterbrücke ausgeführte Wandlerschaltung 12b umfassen.

Dadurch ist gegenüber der Ausführungsform gemäß Fig. 2 die elektrische Maximalleistung des Wechselrichters 30 verdoppelt. Diese Verdoppelung wird dadurch realisiert, dass die gegenüber der Ausführungsform gemäß Fig. 2 zusätzlichen Wandlermodule 10a, 10b mittels einer Verbindung ihrer Zwischenkreisanschlüsse 18a bzw. 18b mit den freien Zwischenkreisanschlüssen 18b bzw. 18a der Wandlermodule 10a bzw. 10b des Wechselrichters 30 gemäß Fig. 2 an den Wechselrichters 30 gemäß Fig. 2 angeschlossen werden.

Diese Verbindung kann direkt erfolgen, so dass die Gehäuse 16 der Wandlermodule 10a, 10b direkt benachbart angeordnet und beispielsweise mit der Oberkante ihrer Gehäuse 16 entlang einer horizontalen Ausrichtungslinie bündig zueinander ausgerichtet sind, wenn die Zwischenkreisanschlüsse 18a, 18b als kompatible Gegensteckverbinder ausgeführt sind und spiegelbildlich zueinander an den entgegengesetzten Seiten der Gehäuse 16 angeordnet sind. Alternativ kann die Verbindung mittels eines Zwischenstücks 28 hergestellt werden, so dass die Wandlermodule räumlich beanstandet und ggf. auch vertikal versetzt zueinander angeordnet sein können.

Der Wechselrichter 30 gemäß Fig. 3 wird in einer Energieerzeugungsanlage, insbesondere in einer Photovoltaikanlage verwendet, indem an die Leistungsanschlüsse der beiden Wandlermodule 10a jeweils ein Photovoltaik-Generator 32 angeschlossen ist, wobei die Photovoltaik-Generatoren 32 wiederum aus einer Reihen- und/oder Parallelschaltung einzelner Photovoltaik-Module bestehen kann. Auch ein Anschluss mehrerer Photovoltaik-Generatoren 32 an eines der Wandlermodule 10a oder an beide Wandlermodule 10a ist denkbar, wenn das bzw. die Wandlermodule 10a mehrere Leistungsanschlüsse 22a aufweisen. Es versteht sich, dass die Photovoltaik-Generatoren 32 auch parallel geschaltet werden können, so dass die von ihnen abgegebene elektrische Leistung zwischen den beiden Wandlermodulen 10a aufteilbar ist. Dabei kann die Parallelschaltung mittels eines Schalters auftrennbar gestaltet sein, so dass beispielsweise in einem Teillastbetrieb, insbesondere wenn beide Photovoltaik-Generatoren 32 zusammen eine elektrische Leistung erzeugen, die kleiner als die Nennleistung eines der Wandlermodule 10a, die Parallelschaltung hergestellt wird, so dass nur ein Wandlermodul 10a betrieben und das andere Wandlermodul 10a deaktiviert wird. Zusätzlich kann in diesem Fall anhand der Steuereinheiten 24 gesteuert werden, welches der Wandlermodule 10a aktiviert ist, und diese Zuordnung zur Minimierung der Betriebszeiten der Wandlermodule 10a regelmäßig getauscht werden. Wenn die beiden Photovoltaik-Generatoren 32 zusammen eine elektrische Leistung erzeugen, die größer als die Nennleistung eines der Wandlermodule 10a ist, kann die Parallelschaltung aufgetrennt werden, so dass die Photovoltaik-Generatoren 32 unabhängig voneinander betrieben werden können, wobei die Wandlermodule 10a insbesondere den Arbeitspunkt mit maximaler elektrischer Leistung (den sog. Maximum Power Point) für die Photovoltaik-Generatoren 32 unabhängig voneinander einstellen können.

Optional kann ein Wandlermodul 10a, 10b eine Trenneinrichtung zwischen Wandlerschaltung 12a, 12b und Kapazität 20a, 20b oder zwischen Kapazität 20a, 20b und den Zwischenkreisanschlüssen 18a, 18b aufweisen, wobei eine solche Trenneinrichtung ein deaktiviertes Wandlermodul 10a, 10b elektrisch vom gemeinsamen Gleichspannungszwischenkreis abkoppeln kann.

Die Wandlermodule 10a umfassen Wandlerschaltungen 12a, die als Gleichspannungswandler ausgeführt sind und die über die Leistungsanschlüsse 22a bezogene elektrische Leistung auf ein anderes Gleichspannungsniveau wandeln und in den Gleichspannungs-zwischenkreis des Wechselrichters 30 einspeisen. Der Gleichspannungszwischenkreis des Wechselrichters 30 wird aus den über die Zwischenkreisanschlüsse 18a, 18b verbundenen Kapazitäten 20a, 20b aller vier Wandlermodule 10a, 10b gebildet.

Die Wandlermodule 10b umfassen Wandlerschaltungen 12b, die als Wechselrichterbrücken ausgeführt sind und die elektrische Leistung aus dem Gleichspannungszwischenkreis entnehmen und in einen Wechselstrom umwandeln. Dieser Wechselstrom kann über die Leistungsanschlüsse 22b in ein daran angeschlossenes Wechselspannungsnetz 34 eingespeist werden. Es versteht sich, dass statt der parallelen Einspeisung in ein Wechselspannungsnetz 34 durch die Wandlermodule 10b auch eine individuelle Einspeisung in zwei separate Wechselspannungsnetze 34 oder zwei getrennte Phasen des Wechselspannungsnetzes 34 realisiert werden kann. Analog zu den Ausführungen bezüglich der Parallelschaltung mehrerer Gleichspannungswandler aufweisender Wandlermodule 10a können auch zwischen Wechselrichterbrücken aufweisenden Wandlermodule 10b geeignete Trenneinrichtungen vorgesehen sein, so dass beispielsweise in einem Teillastbetrieb eines der Wandlermodule 10b deaktiviert werden kann.

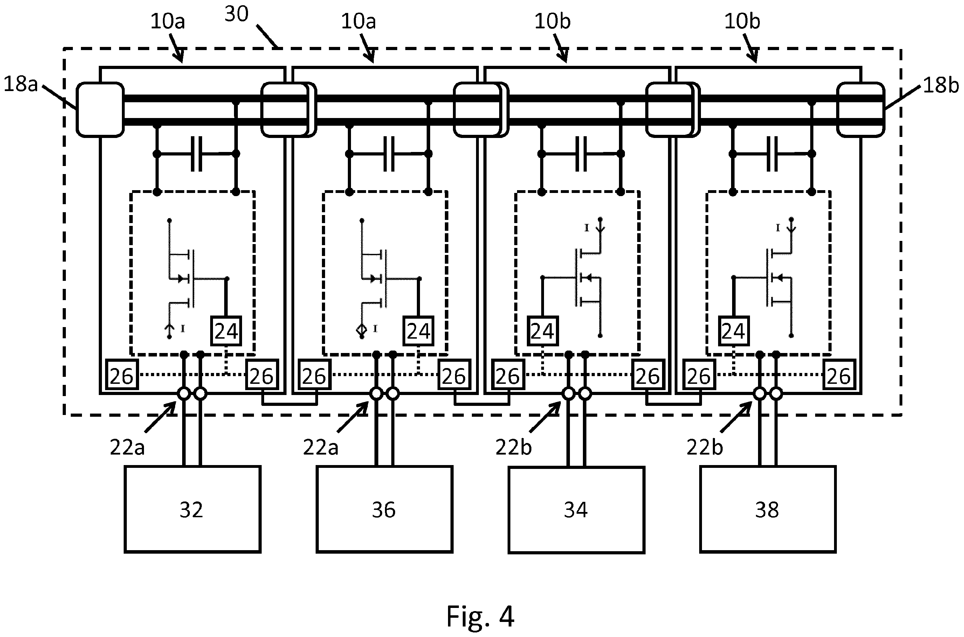

**Fig. 4** verdeutlicht eine weitere Ausführungsform eines Wechselrichters, die sich von der Ausführungsform gemäß Fig. 2 dadurch unterscheidet, dass an eines der einen Gleichspannungswandler umfassenden Wandlermodule 10a ein Speicherelement 36, insbesondere eine wiederaufladbare Batterie angeschlossen ist, wobei der Gleichspannungswandler dieses Wandlermoduls 10a bidirektional ausgeführt ist und das Speicherelement 36 laden und entladen kann. Darüber hinaus ist an eines der eine Wechselrichterbrücke umfassenden Wandlermodule 10b nun ein elektrischer Verbraucher, beispielsweise ein Motor oder ein Heizelement, oder ein isoliertes Haushaltnetz mit einer Mehrzahl von Verbrauchern angeschlossen. An die jeweils anderen Wandlermodule 10a, 10b sind wie in Fig. 3 ein Photovoltaik-Generator 32 bzw. ein Wechselstromnetz 34 angeschlossen. Dabei kann auch die Wechselrichterbrücke des Wandlermoduls 10b bidirektional ausgeführt sein und elektrische Leistung bidirektional über seinen Leistungsanschluss 22b austauschen.

Auch eine derartige Konfiguration des Wechselrichters 30 lässt sich einfach aus der Minimalkonfiguration gemäß Fig. 2 herstellen, indem wie in Zusammenhang mit Fig. 3 bereits beschrieben die zusätzlichen Wandlermodule 10a, 10b über die Zwischenkreisanschlüsse 18a, 18b mit den bestehenden Wandlermodulen 10a, 10b verbunden werden.

Bei der Konfiguration gemäß Fig. 4 ist zusätzlich zu beachten, dass es - je nach elektrischer Nennleistung der einzelnen Wandlermodule 10a, 10b - zu einem Leistungsfluss kommen kann, der die Nennleistung eines einzelnen Wandlermoduls 10a, 10b überschreitet. Insbesondere wenn alle vier Wandlermodule 10a, 10b auf nahezu gleiche Nennleistung ausgelegt sind, kann beispielsweise eine Situation eintreten, in der der Photovoltaik-Generator 32 aufgrund einer hohen Sonneneinstrahlung und damit auch das daran angeschlossene Wandlermodul 10a nahezu mit Nennleistung arbeiten. Wenn gleichzeitig aus dem Speicherelement 36 durch das daran angeschlossene Wandlermodule 10b dessen volle Nennleistung bezogen werden wird, muss die derart in den Gleichspannungszwischenkreis eingebrachte elektrische Leistung von beiden Wandlermodulen 10b entsprechend abgeführt werden. Da dies von einem einzelnen der Wandlermodule 10b nicht gewährleistet werden kann, muss zur Vermeidung der Überlastung der Wandlermodule 10b eine Aufteilung der elektrischen Leistung auf beide Wandlermodule 10b stattfinden. Dies wird anhand einer geeigneten Übermittlung von Vorgabewerten zur Steuerung der einzelnen Wandlermodule 10a, 10b über die Kommunikationsschnittstellen gewährleistet. Dabei können die Vorgabewerte durch eine der Steuereinrichtungen 24 nach dem bereits erwähnten Master-Slave-Prinzip oder von einer nicht dargestellten übergeordneten Steuereinrichtung des Wechselrichters 30 vorgegeben und über die Kommunikationsanschlüsse 26 übermittelt werden.

Die Anordnung der einzelnen Wandlermodule 10a, 10b kann so gewählt werden, dass die zwischen den Leistungsanschlüssen 22a, 22b fließende elektrische Leistung möglichst wenige Zwischenkreisanschlüsse 18a, 18b und möglichst kurze Leitungslängen passieren muss, so dass insbesondere die Strombelastung der elektrischen Verbindungen zwischen den Wandlermodulen 10a, 10b minimiert ist. Abweichend zu einer der Anordnungen gemäß Fig. 3 oder Fig. 4 kann es daher beispielsweise vorteilhaft sein, die Wandlermodule 10a und 10b abwechselnd anzuordnen oder auch die Wandlermodule 10a außen und die Wandlermodule 10b innen oder umgekehrt anzuordnen. Insbesondere kann ein einen Gleichspannungswandler umfassendes Wandlermodul 10a jeweils neben einem eine Wechselrichterbrücke umfassendes Wandlermodul 10b angeordnet sein. Je nach Anzahl und Typ der insgesamt in dem Wechselrichter 30 vorhandenen Wandlermodule 10a, 10b können jedoch auch andere Anordnungen in diesem Sinne optimal sein.

Ein Wechselrichter 30, der eine gleiche oder größere Anzahl an Wandlermodulen 10a, 10b wie die Wechselrichter gemäß Fig. 3 oder Fig. 4 umfasst, bleibt grundsätzlich auch dann betriebsbereit, wenn eines der Wandlermodule 10a, 10b entnommen wird, beispielsweise zu Servicezwecken. In einem solchen Fall kann mittels geeigneter Zwischenstücke 28 eine elektrische Verbindung über die durch vom fehlenden Wandlermodul 10a, 10b hinterlassene Lücke hinweg hergestellt werden. Zusätzlich können die Steuereinrichtungen 24 mittels geeigneter Programmierung auf die ggf. reduzierte Gesamtleistung des Wechselrichters 30 eingerichtet werden.

Es versteht sich, dass die in den Figuren 2 bis 4 dargestellten Anordnungen der Wandlermodule 10a, 10b insofern beispielhaft zu verstehen sind, dass auch eine um 90 Grad gedrehte Anordnung denkbar ist, so dass die Zwischenkreisanschlüsse 18a, 18b an der Ober- und Unterseite oder auch an der Vorder- und Rückseite der Gehäuse 16 angeordnet sind. Mittels eines längeren, ggf. flexiblen oder winklig geformten Zwischenstückes 28 ist auch eine Anordnung der Wandlermodule 10a, 10b in mehreren horizontal, vertikal oder schräg verlaufenden Reihen herstellbar.

Die Gehäuse 16 der Wandlermodule 10a, 10b können eine weitgehend identische Formgebung aufweisen. Eine Verwendung identischer Gehäuse für verschiedene Wandlermodule 10a, 10b ist dabei aus Kostensicht zu bevorzugen, wobei Anpassungen des Gehäuses 16 an verschiedene Funktionen konkreter Wandlermodule 10a, 10b möglich sind. Insbesondere können die Gehäuse 16 innenseitig und außenseitig Befestigungsmittel aufweisen, an die die verschiedenen Bestandteile der Wandlermodule 10a, 10b montiert werden können, beispielsweise die Wandlerschaltungen 12a, 12b innen und Kühleinrichtungen bzw. Kühlkörper außen. Insgesamt können sich dadurch unterschiedliche Gehäuse 16 für unterschiedliche Wandlermodule 10a, 10b ergeben.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Elemente können durch weitere Merkmale ergänzt werden oder die einzigen Elemente sein, auf die sich das jeweilige Verfahren bezieht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### Bezugszeichenliste

- 10, 10a, 10b: Wandlermodul
- 12, 12a, 12b: Wandlerschaltung
- 14, 14a, 14b: Halbleiterschalter
- 16: Gehäuse
- 18a, 18b: Zwischenkreisanschluss
- 20, 20a, 20b: Kapazität
- 22, 22a, 22b: Leistungsanschluss
- 24: Steuereinrichtung
- 26: Kommunikationsanschluss
- 28: Zwischenstück
- 30: Wechselrichter
- 32: Photovoltaik-Generator
- 34: Wechselspannungsnetz
- 36: Speicherelement
- 38: Wechselstromverbraucher
- S: Spiegelachse

## Patentansprüche

1. Wechselrichter (30) für eine Energieerzeugungsanlage, wobei der Wechselrichter (30) mindestens ein erstes Wandlermodul (10a) und ein zweites Wandlermodul (10b) zum Umwandeln elektrischer Leistung umfasst, wobei die Wandlermodule (10a, 10b) jeweils
- ein Gehäuse (16),
- mindestens einen Leistungsanschluss (22a, 22b),
- einen ersten Zwischenkreisanschluss (18a),
- eine mit dem ersten Zwischenkreisanschluss (18a) verbundene Kapazität (20a, 20b) zur Stabilisierung einer an dem ersten Zwischenkreisanschluss (18a) anliegenden Gleichspannung, und
- eine Wandlerschaltung (12a, 12b) mit mindestens einem getaktet angesteuerten leistungselektronischen Halbleiterschalter (14a, 14b)
aufweisen, wobei die Wandlerschaltung (12a) des ersten Wandlermoduls (10a) als Gleichspannungswandler und die Wandlerschaltung (12b) des zweiten Wandlermoduls (10b) als Wechselrichterbrücke ausgeführt ist,
**dadurch gekennzeichnet, dass**
die mindestens zwei Wandlermodule (10a, 10b) jeweils einen mit der Kapazität (20a, 20b) und mit dem ersten Zwischenkreisanschluss (18a) des jeweiligen Wandlermoduls (10a, 10b) verbundenen zweiten Zwischenkreisanschluss (18b) aufweisen und die mindestens zwei Wandlermodule (10a, 10b) über jeweils einen ihrer Zwischenkreisanschlüsse (18a, 18b) direkt oder über Zwischenstücke (28) miteinander verbunden sind, so dass die über die Zwischenkreisanschlüsse (18a, 18b) verbundenen Kapazitäten (20a, 20b) einen gemeinsamen Gleichspannungs-zwischenkreis bilden, wobei der Wechselrichter (30) dazu eingerichtet ist, eine elektrische Leistung eines am Leistungsanschluss (22a) des ersten Wandlermoduls (10a) anschließbaren Gleichstrom-Generators mittels der als Gleichspannungswandler ausgeführten Wandlerschaltung (12a) des ersten Wandlermoduls (10a) auf ein anderes Gleichspannungsniveau zu wandeln, in den Gleichspannungszwischenkreis einzuspeisen, mittels der als Wechselrichterschaltung aufgebauten Wandlerschaltung (12b) des zweiten Wandlermoduls (10b) aus dem Gleichspannungszwischenkreis zu entnehmen, in einen Wechselstrom zu wandeln und diesen Wechselstrom in ein an den Leistungsanschluss (22b) des zweiten Wandlermoduls (12b) anschließbares Wechselspannungsnetz einzuspeisen.

2. Wechselrichter (30) nach Anspruch 1, **dadurch gekennzeichnet, dass** die mit den Zwischenkreisanschlüssen (18a, 18b) der mindestens zwei Wandlermodule (10a, 10b) verbundenen Kapazitäten (20a, 20b) derart ausgelegt sind, dass die Variation der an den Zwischenkreisanschlüssen (18a, 18b) anliegenden Spannung in einem Betrieb des Wechselrichters (30) mit einer elektrischen Maximalleistung auf eine vorgegebene maximale Variation mit einer zum Einspeisen eines Wechselstroms in ein Wechselspannungsnetz nötigen Minimalspannung als untere Grenze begrenzt ist, indem die Kapazität (20a) eines der mindestens zwei Wandlermodule (10a) über mindestens einen der Zwischenkreisanschlüsse (18a, 18b) mit mindestens einer Kapazität (20b) eines weiteren der mindestens zwei Wandlermodule (10b) verbunden ist, wobei die elektrische Maximalleistung von einem oder mehreren der Leistungsanschlüsse (22a, 22b) der mindestens zwei Wandlermodule (10a, 10b) über die Zwischenkreisanschlüsse (18a, 18b) zu einem oder mehreren anderen der Leistungsanschlüsse (22a, 22b) fließt.

3. Wechselrichter (30) nach einem der Ansprüche 1 oder 8, **dadurch gekennzeichnet, dass** der erste Zwischenkreisanschluss (18a) eines der mindestens zwei Wandlermodule (10a, 10b) mit dem zweiten Zwischenkreisanschluss (18b) eines anderen der mindestens zwei Wandlermodule (10a, 10b) verbunden ist.

4. Wechselrichter (30) einem der Ansprüche 1 bis 9, **dadurch gekennzeichnet, dass** die Zwischenkreisanschlüsse (18a, 18b) eines jeden der mindestens zwei Wandlermodule (10a, 10b) jeweils gegenüberliegend an dem Gehäuse (16) des jeweiligen der mindestens zwei Wandlermodule (10a, 10b) angeordnet sind.

5. Wechselrichter (30) einem der Ansprüche 1 bis 4, **dadurch gekennzeichnet, dass** die mindestens zwei Wandlermodule (10a, 10b) eine gleiche Formgebung aufweisen und unter direkter Verbindung jeweils eines der entsprechenden Zwischenkreisanschlüsse (18a, 18b) montiert sind, wobei der erste und der zweite Zwischenkreisanschluss (18a, 18b) eines jeden der mindestens zwei Wandlermodule (10a, 10b) derart zueinander angeordnet sind, dass die mindestens zwei Wandlermodule (10a, 10b) mit einer Gehäuseseite entlang einer horizontalen oder vertikalen Ausrichtungslinie bündig zueinander ausgerichtet sind.

6. Wechselrichter (30) nach einem der Ansprüche 1 bis 5, **dadurch gekennzeichnet, dass** die Wandlermodule (10a, 10b) Steuereinrichtungen (24) und Kommunikationsmittel umfassen, wobei die Steuereinrichtungen (24) dazu eingerichtet sind, über die Kommunikationsmittel mit den Steuereinrichtungen (24) anderer Wandlermodule (10a, 10b) zu kommunizieren.

7. Wechselrichter (30) nach einem der Ansprüche 1 bis 6, **dadurch gekennzeichnet, dass** die Kommunikationsmittel Kommunikationsanschlüsse (26) aufweisen, wobei die Kommunikationsanschlüsse (26) der Wandlermodule (10a, 10b) miteinander verbunden sind.

8. Wechselrichter (30) nach einem der Ansprüche 1 bis 7, **dadurch gekennzeichnet, dass** der mindestens eine Leistungsanschluss (22a) des den Gleichspannungswandler aufweisenden Wandlermoduls (10a) zum Anschluss eines DC-Generators (32), einer DC-Batterie (36) oder einer DC-Last ausgelegt ist und dass der mindestens eine Leistungsanschluss (22b) des die Wechselrichterbrücke aufweisenden Wandlermoduls (10b) zum Anschluss eines Wechselspannungsnetzes (34) oder eines AC-Verbrauchers (38) ausgelegt ist.

## Claims

1. Inverter (30) for an energy generating system, wherein the inverter (30) comprises at least a first converter module (10a) and a second converter module (10b) for converting electrical power, wherein the converter modules (10a, 10b) in each case comprise:
- a housing (16),
- at least one power terminal (22a, 22b),
- a first DC link circuit terminal (18a),
- a capacitance (20a, 20b) connected to the first DC link circuit terminal (18a) and configured to stabilize a DC voltage present at the first DC link circuit terminal (18a), and
- a converter circuit (12a, 12b) comprising at least one power electronic semiconductor switch driven in a clocked manner,
wherein the converter circuit (12a) of the first converter module (10a) is embodied as a DC-DC converter and the converter circuit of the second converter module (10b) is embodied as an inverter bridge,
**characterized in that**
the at least two converter modules (10a, 10b) each comprise a second DC link circuit terminal (18b), which is connected to the capacitance (20a, 20b) and to the first DC link circuit terminal (18a) of the respective converter module (10a, 10b), and that the at least two converter modules (10, 10b) are connected to one another via a respective one of their DC link circuit terminals (18a, 18b) either directly or via connectors (28), such that the capacitances (20a, 20b) connected via the DC link circuit terminals (18a, 18b) form a common DC link circuit, wherein the inverter (30) is configured to convert an electrical power of a direct current generator connectable to the power terminal (22a) of the first converter module (10a) by means of the converter circuit (12a) of the first converter module (10a), which is embodied as a DC-DC converter, to a different direct voltage level; to feed the thus converted electrical power into the DC link circuit; to retrieve the electrical power from the DC link circuit by means of the converter circuit (12b) of the second converter module (10b), which is embodied as a DC-AC converter; to convert the electrical power into an alternating current; and to feed said alternating current into an alternating voltage grid which is connectable to the power terminal (22b) of the second converter module (10b).

2. Inverter (30) according to claim 1, **characterized in that** the capacitances (20a, 20b) connected to the DC link circuit terminals (18a, 18b) of the at least two converter modules (10a, 10b) are configured such that the variation of the voltage present at the DC link circuit terminals (18a, 18b) in operation of the inverter (30) with a maximum electrical power is limited to a predefined maximum variation with a minimum voltage necessary for feeding an alternating current into an alternating voltage grid as a lower limit, by virtue of the capacitance (20a) of one of the at least two converter modules (10a) being connected to at least one capacitance (20b) of another of the at least two converter modules (10b) via at least one of the DC link circuit terminals (18a, 18b), wherein the maximum electrical power flows from one or a plurality of the power terminals (22a, 22b) of the at least two converter modules (10a, 10b) via the DC link circuit terminals (18a, 18b) to one or a plurality of other power terminals (22a, 22b).

3. Inverter (30) according to claim 1 or 2, **characterized in that** the first DC link circuit terminal (18a) of one of the at least two converter modules (10a, 10b) is connected to the second DC link circuit terminal (18b) of another of the at least two converter modules (10a, 10b).

4. Inverter according to one of the preceding claims, **characterized in that** the DC link circuit terminals (18a, 18b) of each of the at least two converter modules (10a, 10b) are arranged in each case oppositely on the housing (16) of the respective one of the at least two converter modules (10a, 10b).

5. Inverter according to one of the preceding claims, **characterized in that** the at least two converter modules (10a, 10b) have an identical shaping and are mounted with direct connection of a respective one of the corresponding DC link circuit terminals (18a, 18b), wherein the first and second DC link circuit terminals (18a, 18b) of each of the at least two converter modules (10a, 10b) are arranged with respect to one another in such a way that the at least two converter modules (10a, 10b) are oriented in alignment with one another with a housing side along a horizontal or vertical orientation line.

6. Inverter according to one of the preceding claims, **characterized in that** the converter modules (10a, 10b) comprise control devices (24) and communication means, wherein the control devices (24) are configured to communicate via the communication means with the control devices (24) of other converter modules (10a, 10b).

7. Inverter according to one of the preceding claims, **characterized in that** the communication means have communication terminals (26), wherein the communication terminals (26) of the converter modules (10a, 10b) are connected to one another.

8. Inverter according to one of the preceding claims, **characterized in that** the at least one power terminal (22a) of the converter module (10a) comprising the DC-DC converter is configured to connect a DC generator (32), a DC battery (36) or a DC load, and **in that** the at least one power terminal (22b) of the converter module (10b) comprising the inverter bridge is configured to connect an alternating voltage grid (34) or an AC load (38).

## Revendications

1. Onduleur (30) pour une installation de production d'énergie, l'onduleur (30) comportant au moins un premier module convertisseur (10a) et un deuxième module convertisseur (10b) destinés à convertir de la puissance électrique, les modules convertisseurs (10a, 10b) possédant respectivement
- un boîtier (16),
- au moins une borne de puissance (22a, 22b),
- une première borne de circuit intermédiaire (18a),
- un condensateur (20a, 20b) relié à la première borne de circuit intermédiaire (18a) destiné à stabiliser une tension continue appliquée à la première borne de circuit intermédiaire (18a), et
- un circuit convertisseur (12a, 12b) comprenant au moins un commutateur semiconducteur électronique de puissance (14a, 14b) à excitation cadencée,
le circuit convertisseur (12a) du premier module convertisseur (10a) étant réalisé sous la forme d'un convertisseur de tension continue et le circuit convertisseur (12b) du deuxième module convertisseur (10b) sous la forme d'un pont onduleur,
**caractérisé en ce que**
les au moins deux modules convertisseurs (10a, 10b) possèdent respectivement une deuxième borne de circuit intermédiaire (18b) reliée au condensateur (20a, 20b) et à la première borne de circuit intermédiaire (18a) du module convertisseur (10a, 10b) respectif et les au moins deux modules convertisseurs (10a, 10b) sont reliés l'un à l'autre respectivement par le biais de l'une de leurs bornes de circuit intermédiaire (18a, 18b) directement ou par le biais de pièces intermédiaires (28), de sorte que les condensateurs (20a, 20b) reliés par le biais des bornes de circuit intermédiaire (18a, 18b) forment un circuit intermédiaire de tension commun, l'onduleur (30) étant conçu pour convertir une puissance électrique d'un générateur de courant continu qui peut être raccordé à la borne de puissance (22a) du premier module convertisseur (10a) à un autre niveau de tension continue au moyen du circuit convertisseur (12a) du premier module convertisseur (10a) réalisé sous la forme d'un convertisseur de tension continue, l'injecter dans le circuit intermédiaire de tension continue, la prélever du circuit intermédiaire de tension continue au moyen du circuit convertisseur (12b) du deuxième module convertisseur (10b) réalisé sous la forme d'un circuit onduleur, la convertir en un courant alternatif et injecter ce courant alternatif dans un réseau de tension alternative pouvant être raccordé à la borne de puissance (22b) du deuxième module convertisseur (12b).

2. Onduleur (30) selon la revendication 1, **caractérisé en ce que** les condensateurs (20a, 20b) reliés aux bornes de circuit intermédiaire (18a, 18b) des au moins deux modules convertisseurs (10a, 10b) sont conçus de telle sorte que la variation de la tension appliquée aux bornes de circuit intermédiaire (18a, 18b) dans un fonctionnement de l'onduleur (30) à une puissance électrique maximale est limitée à une variation maximale prédéfinie en prenant pour limite inférieure une tension minimale nécessaire pour l'injection d'un courant alternatif dans un réseau de tension alternative, en reliant le condensateur (20a) de l'un des au moins deux modules convertisseurs (10a) à au moins un condensateur (20b) d'un autre des au moins deux modules convertisseurs (10b) par le biais d'au moins l'une des bornes de circuit intermédiaire (18a, 18b), la puissance électrique maximale s'écoulant de l'un ou plusieurs des bornes de puissance (22a, 22b) des au moins deux modules convertisseurs (10a, 10b) à une ou plusieurs autres des bornes de puissance (22a, 22b) par le biais des bornes de circuit intermédiaire (18a, 18b).

3. Onduleur (30) selon l'une des revendications 1 ou 2, **caractérisé en ce que** la première borne de circuit intermédiaire (18a) de l'un des au moins deux modules convertisseurs (10a, 10b) est reliée à la deuxième borne de circuit intermédiaire (18b) d'un autre des au moins deux modules convertisseurs (10a, 10b) .

4. Onduleur (30) selon l'une des revendications 1 à 3, **caractérisé en ce que** les bornes de circuit intermédiaire (18a, 18b) de chacun des au moins deux modules convertisseurs (10a, 10b) sont disposées respectivement en vis-à-vis sur le boîtier (16) de celui respectif des au moins deux modules convertisseurs (10a, 10b).

5. Onduleur (30) selon l'une des revendications 1 à 4, **caractérisé en ce que** les au moins deux modules convertisseurs (10a, 10b) possèdent un façonnage identique et sont montés en reliant directement respectivement de l'une des bornes de circuit intermédiaire (18a, 18b) correspondantes, la première et la deuxième borne de circuit intermédiaire (18a, 18b) de chacun des au moins deux modules convertisseurs (10a, 10b) étant disposées l'une par rapport à l'autre de telle sorte que les au moins deux modules convertisseurs (10a, 10b) sont orientés à fleur l'un de l'autre par un côté boîtier le long d'une ligne d'orientation horizontale ou verticale.

6. Onduleur (30) selon l'une des revendications 1 à 5, **caractérisé en ce que** les modules convertisseurs (10a, 10b) comportent des dispositifs de commande (24) et des moyens de communication, les dispositifs de commande (24) étant conçus pour communiquer avec les dispositifs de commande (24) d'autres modules convertisseurs (10a, 10b) par le biais des moyens de communication.

7. Onduleur (30) selon l'une des revendications 1 à 6, **caractérisé en ce que** les moyens de communication possèdent des bornes de communication (26), les bornes de communication (26) des modules convertisseurs (10a, 10b) étant reliées entre elles.

8. Onduleur (30) selon l'une des revendications 1 à 7, **caractérisé en ce que** l'au moins une borne de puissance (22a) du module convertisseur (10a) qui possède le convertisseur de tension continue est conçue pour le raccordement d'un générateur CC (32), d'une pile/batterie CC (36) ou d'une charge CC et **en ce que** l'au moins une borne de puissance (22b) du module convertisseur (10b) qui possède le pont onduleur est conçue pour le raccordement d'un réseau de tension alternative (34) ou d'un récepteur CA (38).
